# EUROPEAN PATENT APPLICATION

(11) **EP 4 761 509 A1**
(43) Date of publication of application: **17.06.2026**
(21) Application number: 25219573.0
(22) Date of filing: 28.11.2025
(51) Int. Cl.: H10D 62/10, H10D 30/01, H10D 30/43, H10D 30/00, H10D 84/01

(54) **DIFFUSION BARRIER LINER FOR NANORIBBON TRANSISTOR PROCESSING**

(30) Priority: 10.12.2024 US 202418975318
(71) Applicant: Intel Corporation, Santa Clara, CA 95054 (US)
(72) Inventor: YEUNG, Chun Wing, Portland, OR 97229 (US); GHANI, Tahir, Portland, OR 97229 (US); PACKAN, Paul, Hillsboro, OR 97124 (US); LIN, Chia-Ching, Portland, OR 97229 (US); ARMSTRONG, Mark, Forest Grove, OR 97116 (US); LUO, Yanbin, Portland, OR 97229 (US); JANG, Minwoo, Portland, OR 97229 (US); ZHANG, Yang, Rio Rancho, NM 87124 (US); LIN, Chung-Hsun, Portland, OR 97229 (US); HU, Lin, San Jose, CA 95124 (US); CHU, Tao, Portland, OR 97229 (US); XU, Guowei, Portland, OR 97229 (US); CHAO, Robin, Portland, OR 97209 (US); ZHANG, Feng, Portland, OR 97229 (US); HUNG, Ting-Hsiang, Santa Clara, CA 95051 (US); ZHANG, Kan, Hillsboro, OR 97123 (US); WANG, Qiwen, Portland, OR 97229 (US)
(74) Representative: Samson & Partner Patentanwälte mbB

(57) **Abstract**

Described herein are nanoribbon transistors and processes for forming nanoribbon transistors that include a nitride liner to protect the channel material during an oxide anneal. An oxide may be used to fill trenches between stacks of nanoribbons; the oxide is annealed, and then the oxide is recessed, forming isolation regions. Source and drain regions are formed over the isolation regions. In the resulting devices, the isolation regions have a liner layer that includes nitrogen. An additional oxide liner may be around the nitride liner.

## Description

### Background

Non-planar transistors are three-dimensional electronic devices that deviate from a traditional flat transistor design. Compared to planar transistors, non-planar transistors can provide improved control over current flow, reduced leakage, and enhanced performance, making it a key technology for smaller, faster, and more energy-efficient electronic devices. Examples of non-planar transistors include fin-shaped field-effect transistors, referred to as FinFETs, and gate-all-around (GAA) transistors. GAA transistors, also referred to as surrounding-gate transistors, have a gate material that surrounds a channel region on all sides. GAA transistors may be nanoribbon-based or nanowire-based.

In a nanoribbon transistor, a gate stack that may include one or more gate electrode materials and a gate dielectric may be provided around a portion of an elongated semiconductor structure called "nanoribbon", forming the gate stack on all sides of the nanoribbon. A source region and a drain region are provided on the opposite ends of the nanoribbon(s) and on either side of the gate stack, forming, respectively, a source and a drain of the nanoribbon transistor. The source and drain regions are insulated from the gate stack, so that the voltages at the three terminals (gate, source, and drain) may be separately controlled.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a cross-section across a nanoribbon-based transistor showing the source, gate, and drain, according to some embodiments of the present disclosure.
FIG. 1B is a cross-section of the nanoribbon-based transistor through the plane AA' in FIG. 1A, according to some embodiments of the present disclosure.
FIG. 2 is a flow diagram of a process for fabricating nanoribbon-based transistors using a diffusion barrier liner during an oxide anneal, according to some embodiments of the present disclosure.
FIG. 3 is a cross-section of layers of alternating materials for forming nanoribbons, according to some embodiments of the present disclosure.
FIG. 4 is a cross-section illustrating dummy gate regions over the layers of FIG. 3, according to some embodiments of the present disclosure.
FIG. 5 is a cross-section illustrating regions etched for forming sources and drains, according to some embodiments of the present disclosure.
FIG. 6 is a cross-section illustrating a first liner layer deposited around the etched fins, according to some embodiments of the present disclosure.
FIG. 7 is a cross-section illustrating a second liner layer deposited over the first liner layer, according to some embodiments of the present disclosure.
FIG. 8 is a cross-section illustrating an isolation material deposited over the liners, according to some embodiments of the present disclosure.
FIG. 9 is a cross-section illustrating the recessed isolation material, according to some embodiments of the present disclosure.
FIG. 10 is a cross-section illustrating the removal of the liner materials in areas above the isolation material, according to some embodiments of the present disclosure.
FIG. 11 is a cross-section illustrating growth of the sources and drains, according to some embodiments of the present disclosure.
FIG. 12A is a cross-section illustrating formation of the gate stack, according to some embodiments of the present disclosure.
FIG. 12B is an enlarged view of a portion of FIG. 12A, illustrating one of the lines isolation regions in greater detail, according to some embodiments of the present disclosure.
FIGS. 13A and 13B are top views of a wafer and dies that include one or more nanoribbon transistors with lined isolation regions accordance with any of the embodiments disclosed herein.
FIG. 14 is a cross-sectional side view of an IC device that may include one or more nanoribbon transistors with lined isolation regions in accordance with any of the embodiments disclosed herein.
FIG. 15 is a cross-sectional side view of an IC device assembly that may include nanoribbon transistors with lined isolation regions in accordance with any of the embodiments disclosed herein.
FIG. 16 is a block diagram of an example computing device that may include one or more nanoribbon transistors with lined isolation regions in accordance with any of the embodiments disclosed herein.

### Detailed Description

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Described herein are integrated circuit (IC) devices that include non-planar transistors, such as nanoribbon-based transistors, in which a nitride liner is used to protect the channel materials during formation of oxide-based isolation regions below and between adjacent transistors. The resulting devices include lined isolation regions in regions of the substrate between adjacent nanoribbon stacks. In general, non-planar transistors provide several advantages over planar transistor architectures. For example, non-planar transistors provide improved electrostatic transistor control and faster transistor speeds relative to other transistor architectures. For certain applications, nanoribbon-based channels are particularly advantageous, providing increased drive current at smaller scales relative to other non-planar architectures.

Transistors typically include a gate stack coupled to a semiconductor channel, which may be a nanoribbon or a stack of nanoribbons. A gate stack often includes a gate electrode and a gate dielectric, with the gate dielectric formed between the gate electrode and the channel material. In a nanoribbon transistor, the gate dielectric is formed around each nanoribbon, and the gate electrode is formed over and around the gate dielectric, including in spaces between adjacent nanoribbons in the stack. In some implementations of nanoribbon transistors, the gate dielectric is omitted. A source region is formed at one end of the nanoribbons, and a drain region is formed at the opposite end of the nanoribbons, thus realizing a three-terminal device.

To produce stacks of nanoribbons, alternating layers of a semiconductor channel material (e.g., silicon) and a sacrificial material (e.g., germanium or silicon germanium) are deposited over a substrate. An upper surface is patterned, and portions of the stacked materials are etched, leaving fin-shaped regions of the etched materials over the substrate. The etching process removes portions of the substrate below the stacked semiconductor materials. The etched portions of the substrate are filled in by an isolation material, e.g., silicon oxide, prior to forming source, drains, and gates around the nanoribbon channels. The source and drains are formed over the isolation material, and then the sacrificial material is removed and replaced by the gate stack.

The isolation material is deposited as a flowable oxide that fills in the etched areas, including areas adjacent to the fins of stacked channel material and sacrificial material. After being deposited, the isolation material is annealed to improve material properties, e.g., reduce porousness and increase hardness. During the annealing process, oxygen from the isolation material may migrate into the stacked semiconductor materials, which may cause germanium from the sacrificial material to migrate into the silicon channels, which is undesirable. In particular, during the anneal, oxygen in the isolation material may oxidize the silicon in sacrificial layers of silicon germanium; this produces free germanium, which may travel into adjacent silicon channels.

As described herein, to protect the channel and sacrificial materials during the oxide anneal, a liner is deposited over the etched semiconductor stacks prior to depositing the flowable oxide for forming the isolation regions. The liner may include nitrogen, e.g., silicon nitride, or another combination of silicon, nitrogen, carbon, and/or oxygen. The liner is an oxide diffusion barrier that prevents or reduces migration of oxygen from the isolation material into the stacked channel and sacrificial materials.

In some embodiments, two liners are deposited: an oxide liner directly on the stacked semiconductor materials, and the oxide diffusion barrier (e.g., a nitride liner) over the oxide liner. The oxide liner may be thin (e.g., less than 2 nanometers), and due to the low volume, may cause minimal oxidization of the channel material. The oxide liner, which is an inner liner relative to the stacked semiconductor materials, may be included because the nitride liner (the outer liner) could stress the channel material during the annealing process if applied directly to the stacked semiconductor materials. The oxide liner protects the channel material from the nitride liner, while the nitride diffusion barrier liner blocks migration of oxygen from the isolation material into the stacked semiconductors.

After annealing the isolation material, the isolation material is recessed below the stacked semiconductor materials, leaving isolation regions within the substrate. The liner(s) are also removed around the stacked semiconductor materials. However, the liner(s) remains in the substrate, with the isolation region nested within the liner(s). Relative to the isolation region, the diffusion barrier liner is the inner liner, and the oxide liner is the outer liner, with the diffusion barrier liner (e.g., the nitride liner) between the isolation region and the oxide liner. The diffusion barrier liner may have a width of, e.g., between 1 and 5 nanometers.

The nanoribbon transistors with lined isolation regions described herein may be implemented in one or more components associated with an IC. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well known features are omitted or simplified in order not to obscure the illustrative implementations.

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. The meaning of "a," "an," and "the" include plural references. The meaning of "in" includes "in" and "on."

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. The terms "substantially," "close," "approximately," "near," and "about," generally refer to being within +/- 20% of a target value, unless specified otherwise. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art. For example, as used herein, a "logic state" of a ferroelectric memory cell refers to one of a finite number of states that the cell can have, e.g. logic states "1" and "0," each state represented by a different polarization of the ferroelectric material of the cell. In another example, as used herein, a "READ" and "WRITE" memory access or operations refer to, respectively, determining/sensing a logic state of a memory cell and programming/setting a logic state of a memory cell. In other examples, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. In yet another example, a "high-k dielectric" refers to a material having a higher dielectric constant (k) than silicon oxide. The terms "oxide," "carbide," "nitride," etc. refer to compounds containing, respectively, oxygen, carbon, nitrogen, etc.

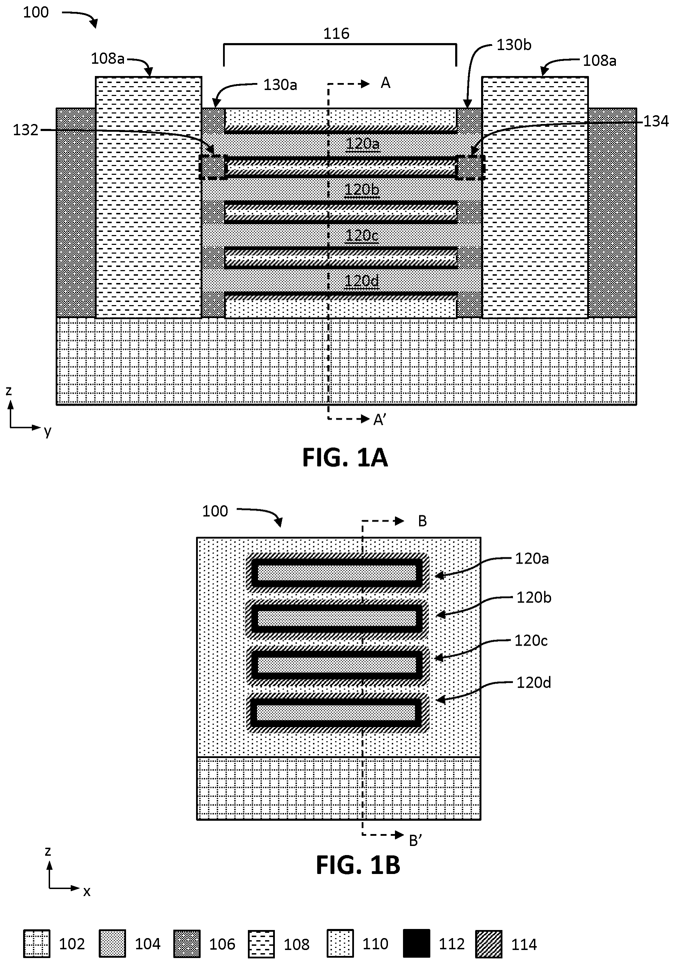

For convenience, if a collection of drawings designated with different letters are present, e.g., FIGS. 1A-1B, such a collection may be referred to herein without the letters, e.g., as "FIG. 1."

FIGs. 1A-1B illustrate an example architecture of a nanoribbon-based transistor. FIG. 1A is a cross-section across a transistor 100 showing the source, gate, and drain. FIG. 1B is a cross-section across the gate regions of the transistor 100. FIG. 1B is a cross-section through the plane AA' in FIG. 1A, and FIG. 1A is a cross-section through the plane BB' in FIG. 1B.

A number of elements referred to in the description of FIGs. 1A, 1B, 3-13 and with reference numerals are illustrated in these figures with different patterns, with a legend at the bottom of the page showing the correspondence between the reference numerals and patterns. The legend illustrates that FIGs. 1A and 1B use different patterns to show a support structure 102, a channel material 104, a dielectric material 106, a source or drain (S/D) contact 108, a gate electrode 110, an oxide 112, and a high-k dielectric 114.

In the drawings, some example structures of various devices and assemblies described herein are shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

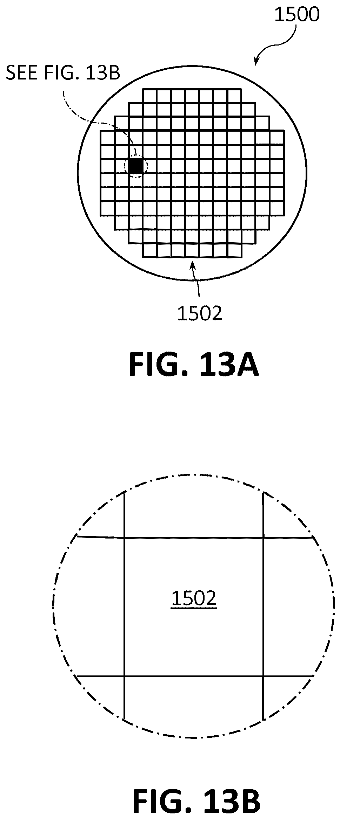

In general, implementations of the present disclosure may be formed or carried out on a support structure, e.g., the support structure 102 illustrated in FIG. 1. The support structure 102 may be, e.g., a substrate, a die, a wafer or a chip. For example, the support structure may be the wafer 1500 of FIG. 13A, discussed below, and may be, or be included in, a die, e.g., the singulated die 1502 of FIG. 13B, discussed below. The support structure 102 extends along the x-y plane in the coordinate system shown in FIG. 1.

In some embodiments, the support structure may be a substrate that includes silicon and/or hafnium. More generally, the support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which a semiconductor device including one or more nanoribbon transistors, as described herein, may be built falls within the spirit and scope of the present disclosure.

In FIGs. 1A and 1B, a transistor 100 is formed over a support structure 102. The transistor 100 includes a channel material 104 formed into four nanoribbons stacked on top of each other. The channel material 104 may be a semiconductor, such as silicon or other semiconductor materials described herein.

The transistor 100 includes nanoribbons 120a, 120b, 120c, and 120d, referred to collectively as nanoribbons 120 or individually as a nanoribbon 120. Each nanoribbon 120 is at a different height in the z-direction in the orientation shown in FIGs. 1A and 1B, i.e., a different distance from the support structure 102, where the nanoribbon 120a is the greatest distance from the support structure 102, and the nanoribbon 120d is the smallest distance from the support structure 102. S/D contacts 108a and 108b are formed at either end of the nanoribbons 120, as illustrated in FIG. 1A.

The S/D contacts 108 may be formed from one or more layers of doped semiconductors, metals, metal alloys, or other materials. In some embodiments described herein, the S/D contacts 108 may include a doped semiconductor, such as silicon or another semiconductor doped with an N-type dopant or a P-type dopant. In some embodiments, the S/D contacts 108 may include multiple layers with different levels of conductivity, e.g., a doped semiconductor followed by a more highly doped semiconductor, or a semiconductor followed by metal.

A central portion of each of the nanoribbons 120 is surrounded by a gate stack 116, which in this example, includes a gate electrode 110 and gate dielectrics 112 and 114. Nanoribbon transistors often include a gate dielectric that surrounds the nanoribbons 120, and a gate electrode that surrounds the gate dielectric. In this example, the gate dielectric around each nanoribbon 120 includes a layer of an oxide 112 and a layer of a high-k dielectric 114. The oxide 112 is grown directly on the nanoribbons 120, and the high-k dielectric 114 surrounds the oxide 112. The oxide 112 may include oxygen in combination with the channel material 104. For example, if the nanoribbon channels are formed from silicon, the gate dielectric may include a layer of silicon oxide. The high-k dielectric 114 may be formed over the oxide 112. The gate electrode 110 surrounds the high-k dielectric 114. In this example, the gate electrode 110 is above and below the nanoribbon stack, and between adjacent nanoribbons 120.

The gate electrode 110 includes a conductive material, such as a metal. The gate electrode 110 may include at least one P-type work function metal or N-type work function metal, depending on whether the transistor 100 is a PMOS transistor or an NMOS transistor. For a PMOS transistor, metals that may be used for the gate electrode 110 may include, but are not limited to, ruthenium, palladium, platinum, cobalt, nickel, and conductive metal oxides (e.g., ruthenium oxide). For an NMOS transistor, metals that may be used for the gate electrode 110 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 110 may include a stack of two or more metal layers, where one or more metal layers are work function metal layers and at least one metal layer is a fill metal layer.

In various embodiments, the high-k gate dielectric 114 may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, one or both of the gate dielectrics 112 and 114 may have a thickness between about 0.5 nanometers and 3 nanometers, including all values and ranges therein, e.g., between about 1 and 3 nanometers, or between about 1 and 2 nanometers.

Regions of the transistor 100 outside of the nanoribbons 120, gate stack 116, and S/D contacts 108 are filled in with a dielectric material 106. In the region between the gate stack 116 and the S/D contacts 108, the dielectric material 106 forms a series of cavity spacers 130. In particular, a set of cavity spacers 130a (including the cavity spacer 132) are in the region between the S/D contact 108a and the gate stack 116, and a set of cavity spacers 130b (including the cavity spacer 134) are in the region between the S/D contact 108b and the gate stack 116. Some of the cavity spacers 130 are between adjacent nanoribbons. For example, the cavity spacer 132 is between the nanoribbon 120a and the nanoribbon 120b, and in particular, between two ends of the nanoribbons 120a and 120b. A portion of the gate stack 116 (in this case, going from top to bottom, a layer of oxide 112, a layer of high-k dielectric 114, a layer of gate electrode 110, a second layer of high-k dielectric 114, and a second layer of oxide 112) are on the right side of the cavity spacer 132, and the S/D contact 108a is on the left side of the cavity spacer 132, in the orientation shown. The cavity spacer 134 in the second set of cavity spacers 130b is on the opposite side of the transistor 100 from the cavity spacer 132. The cavity spacer 134 is between the opposite ends of the nanoribbons 120a and 120b from the cavity spacer 132, and the cavity spacer 134 is next to an opposite end of the gate stack 116 from the cavity spacer 132. Thus, the gate stack 116 (including the oxide 112, high-k dielectric 114, and gate electrode 110) is between the cavity spacers 132 and 134.

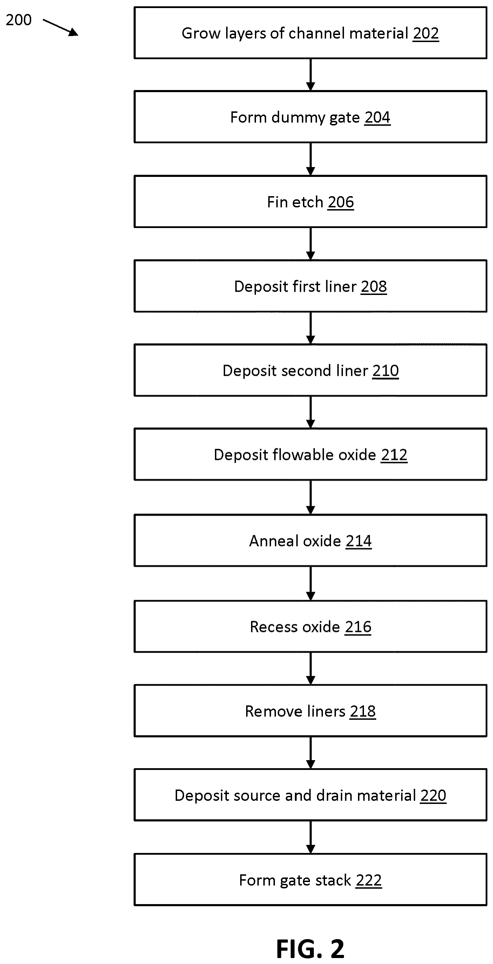

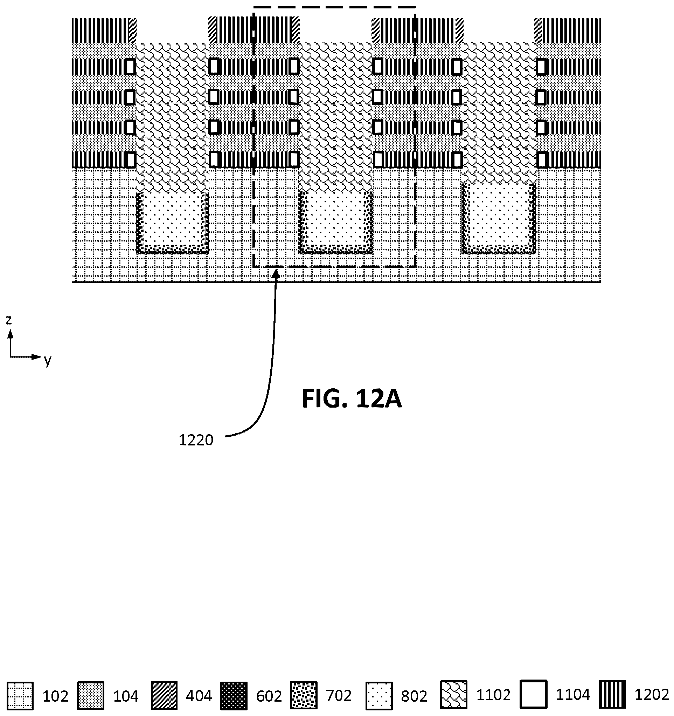

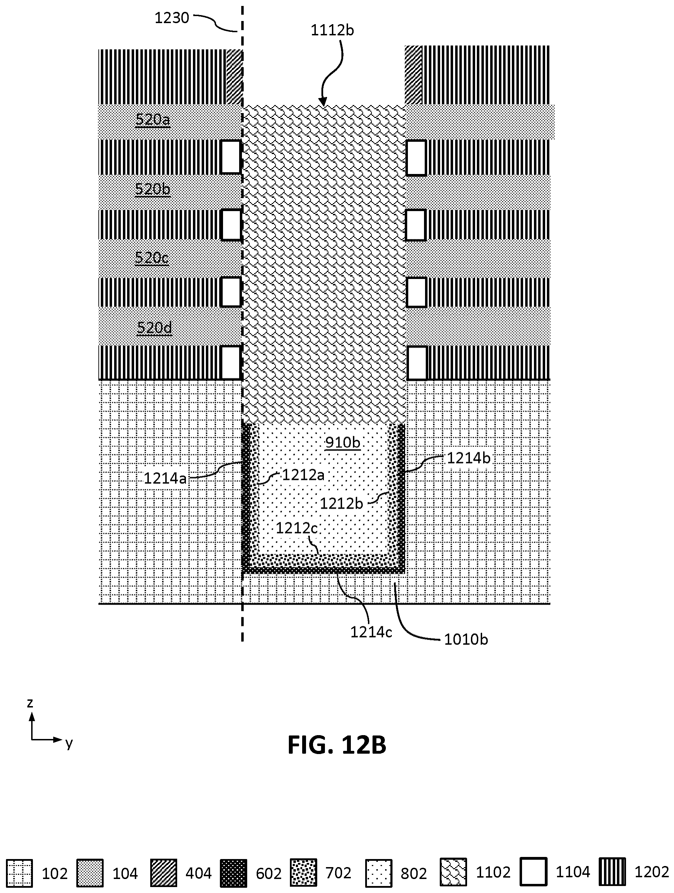

FIGs. 1A and 1B illustrate a single transistor. Isolation regions may be formed in the support structure 102 between adjacent transistors. For example, prior to forming the S/D contacts 108, trenches may be formed in the support structure 102, and an oxide dielectric material may be deposited into the trenches. The isolation trenches may include barrier diffusion liners, e.g., as shown in FIG. 12. The process for forming the lined isolation trenches is described with respect to FIGs. 2-12.

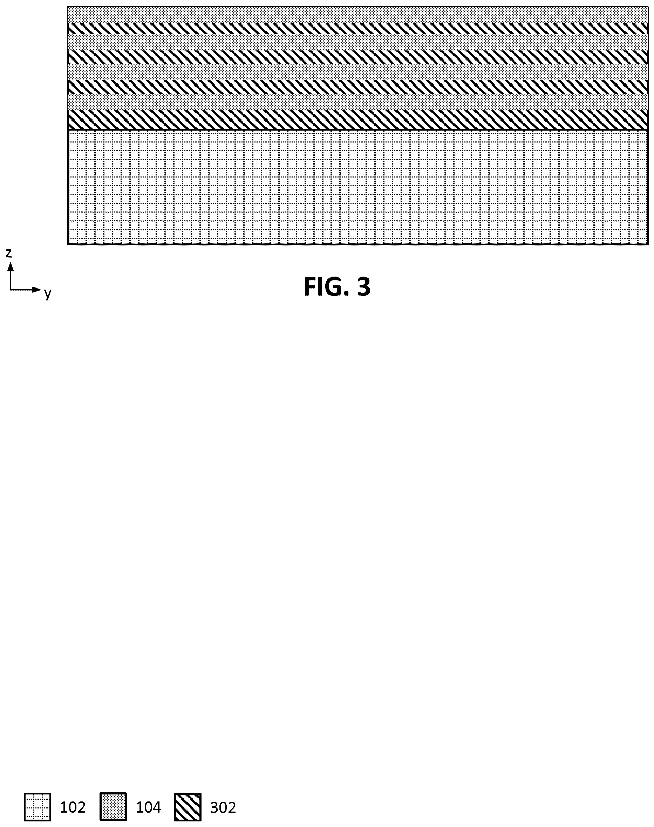

FIG. 2 is a flowchart illustrating an example processing method 200 for fabricating nanoribbon-based transistors using a diffusion barrier liner during an oxide anneal, according to some embodiments of the present disclosure. FIGs. 3-12 illustrate various steps in the processing method 200 of FIG. 2, according to some embodiments of the present disclosure. In general, the processing method 200 is performed across a wafer, with many individual transistors formed on the wafer. FIGs. 3-12 illustrate cross-sections of processing steps across several transistors. Additional steps may be performed before, during, and/or after the processing method 200 to produce a device that includes the lined isolation regions described herein, e.g., to produce the nanoribbon transistor shown in FIG. 1, or to produce an IC device that includes nanoribbon transistors with lined isolation regions.

At 202, a process for growing a channel material over a support structure is performed. To produce a stack of nanoribbons, the channel material may be grown in layers with a sacrificial material between layers of channel material. FIG. 3 is a cross-section illustrating layers of alternating materials 104 and 302 formed over a support structure 102, e.g., a substrate as described with respect to FIG. 1. The alternating materials 104 includes layers of the channel material 104 separated by layers of a sacrificial material 302. In this example, four layers of the channel material 104 are illustrated; in other examples, fewer or additional layers (e.g., two layers, three layers, five layers, six layers, or more) may be included.

In general, to form nanoribbon channels, alternating layers of the channel material 104 and the sacrificial material 302 are deposited over the support structure 102. The channel material 104 and sacrificial materials 302 include different materials. In one example, the channel material 104 is silicon, while the sacrificial material 302 includes silicon and germanium. The sacrificial material 302 may be chosen to have a similar crystal structure to the channel material 104, so that monocrystalline layers of the channel material 104 (or substantially monocrystalline layers, e.g., with a grain size of at least 5 nanometers, at least 20 nanometers, at least 50 nanometers, or at least 100 nanometers) and monocrystalline layers of the sacrificial material 302 (or substantially monocrystalline layers) may be formed over each other. In different embodiments, the channel material 104 and/or the sacrificial material 302 may be formed of any suitable single-crystal material, such as sapphire, quartz, silicon, a compound of silicon (e.g., silicon oxide), indium phosphide, germanium or a germanium alloy (e.g., silicon germanium), gallium, arsenic (e.g., an arsenide III compound, where arsenic III is in combination with another element such as boron, aluminum, gallium, or indium), or any group III-V material (i.e., materials from groups III and V of the periodic system of elements).

More generally, the channel material 104 may be composed of semiconductor material systems including, for example, N-type or P-type materials systems. In other embodiments, the channel material 104 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. The channel material 104 may include one or more of cobalt oxide, copper oxide, ruthenium oxide, nickel oxide, niobium oxide, copper peroxide, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminum gallium nitride, indium phosphite, black phosphorus, zinc sulfide, indium sulfide, gallium sulfide, each of which may possibly be doped with one or more of gallium, indium, aluminum, fluorine, boron, phosphorus, arsenic, nitrogen, tantalum, tungsten, and magnesium, etc.

In some embodiments, multiple channel materials may be included within an IC device. For example, an IC device may include both N-type metal-oxide-semiconductor (NMOS) transistors and P-type MOS (PMOS) transistors, e.g., alternating rows of NMOS and PMOS transistors. NMOS and PMOS logic can use different groups of channel material 104, e.g., silicon may be used to form an N-type semiconductor channel, while silicon germanium may be used to form a P-type semiconductor channel. In some embodiments, a single channel material 104 is used (e.g., silicon), and different portions (e.g., channel material to form different transistors) may include different dopants, e.g., N-type dopants for NMOS transistors and P-type dopants for PMOS transistors.

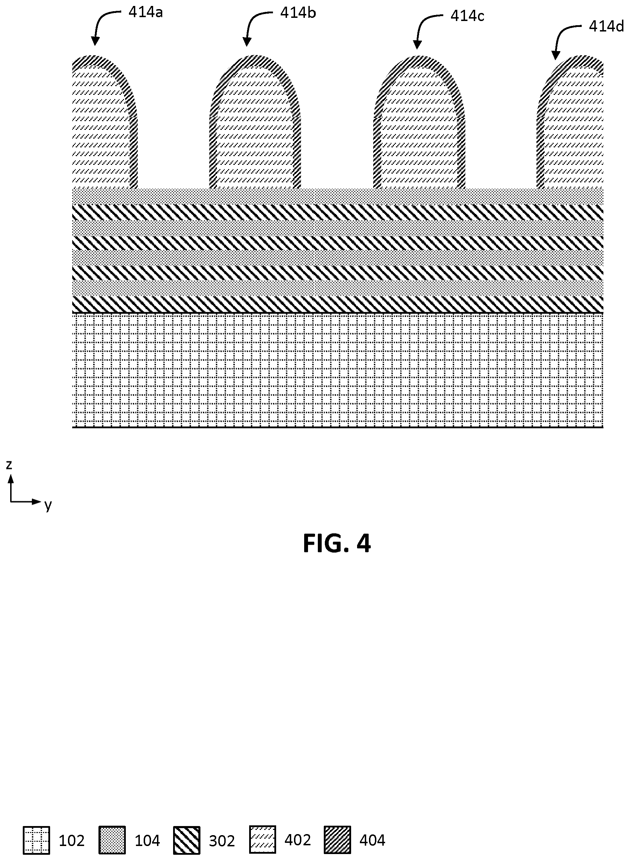

Returning to FIG. 2, at 204, a process to form dummy gates over the layers of channel material is performed. The dummy gates may be formed using photolithographic patterning processes, to deposit dummy gate materials in certain areas and not in others (or to remove dummy gate materials from certain areas but not from others). As illustrated in FIG. 4, a series of dummy gates 414 (including dummy gates 414a, 414b, 414c, and 414d) are formed over the alternating layers of the channel material 104 and the sacrificial material 302. The dummy gates 414 include a dummy gate material 402 and a gate spacer 404. The dummy gates 414 are spaced apart, at the locations for forming gates (e.g., the gate stack 116 in FIG. 1) later in the process. At a later part in the process, the dummy gates 414 and, in particular, the dummy gate material 402 is replaced with a gate stack. The gate spacer 404 may be included in a finished device, e.g., to electrically isolate the gate electrode from source or drain contacts formed on either side of the gate spacer 404.

The dummy gate material 402 and the gate spacer 404 may each be a dielectric material. Suitable dielectric materials may include low-k or high-k dielectrics including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

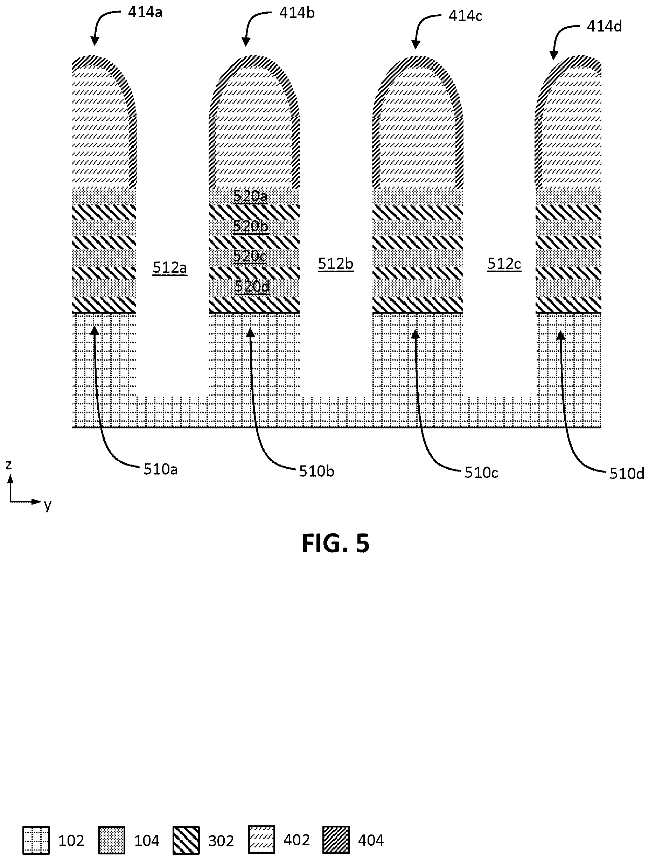

Returning to FIG. 2, at 206, a process to etch fins from the stacked semiconductor materials is performed. The fin etch provides individual stacks of nanoribbons, with sacrificial material layered between the nanoribbons. FIG. 5 illustrates the nanoribbon channel material 104 after fins have been etched to form individuated channels for different transistors. For example, the dummy gates 414 may act as a pattern, and portions of the alternating layers between the dummy gates 414 are removed, leaving the stacks 510a, 510b, 510c, and 510d illustrated in FIG. 5. The stacks 510 may be also referred to as fins, due to their fin-like shape. Each stack 510 is under a respective dummy gate 414, e.g., the stack 510b is under the dummy gate 414b. The stacks 510 are separated by etched regions 512a, 512b, and 512c, e.g., the etched region 512a is between the stacks 510a and 510b. A portion of the support structure 102 is also etched, so that the etched regions 512 extend into the support structure 102. The etched regions 512 are regions in which the lined isolation regions and the S/D regions for transistors are formed.

In the example shown in FIG. 5, the channel material 104 is formed into four nanoribbons stacked on top of each other. For example, the stack 510b includes nanoribbons 520a, 520b, 520c, and 520d. Each nanoribbon 520 in the stack 510b is at a different height in the z-direction in the orientation shown in FIG. 5, i.e., a different distance from the support structure 102. Each of the stacks 510 has four nanoribbons. In other embodiments, the stacks 510, and transistors formed from the nanoribbon stacks, may each have fewer nanoribbons (e.g., two or three nanoribbons), or more than four nanoribbons (e.g., five nanoribbons, six nanoribbons, etc.). In this example, the sacrificial material 302 is below the lowest nanoribbon 520d (i.e., between the support structure 102 and the nanoribbon 520d) and between adjacent nanoribbons (e.g., between nanoribbon 520a and 520b, and between nanoribbon 520b and 520c). While not shown in FIG. 5, in some embodiments, a layer of the sacrificial material 302 is above the highest nanoribbon (i.e., between nanoribbon 520a and the dummy gate 414b).

The nanoribbons 520 each have an elongated structure that extends over the support structure 102. Each nanoribbon 520 extends primarily in the y-direction in the coordinate system used in FIGs. 3-12, and thus the nanoribbon structures are considered to be elongated in this direction. The direction in which the nanoribbons 520 extend is parallel to the support structure 102; this direction in which the nanoribbons 520 extend is also parallel to the other nanoribbons in the stack.

Returning to FIG. 2, at 208, a first liner is deposited over the fins and in the etched regions. The first liner may be an oxide liner, such as silicon dioxide (SiO₂), that protects the channel material 104 during further processing steps. For example, the first liner may protect the channel materials 104 from a second liner deposited over the first liner. The first liner is conformally deposited. For example, atomic layer deposition (ALD) or chemical vapor deposition (CVD) may be used to deposit the first liner. Conformal deposition generally refers to deposition of a certain coating on any exposed surface of a given structure. A conformal coating may, therefore, be understood as a coating that is applied to exposed surfaces of a given structure, and not, for example, just to the horizontal surfaces.

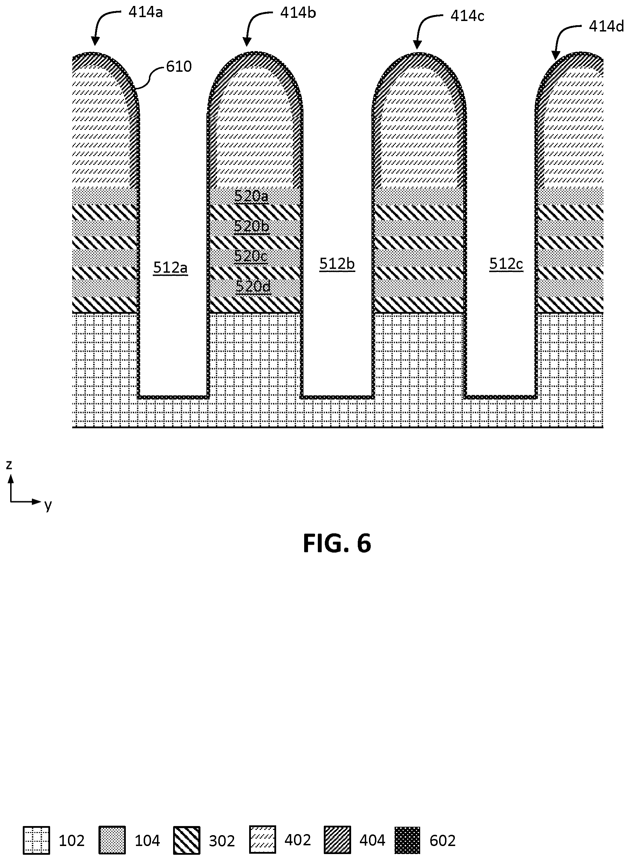

FIG. 6 is a cross-section illustrating a first liner layer 610 deposited around the etched fins, according to some embodiments of the present disclosure. The first liner layer 610 is formed from a first liner material 602. The first liner material 602 may include oxygen. The first liner material 602 may further include silicon, e.g., the first liner material 602 may be silicon dioxide. In some embodiments, the first liner material 602 includes one or more other elements, e.g., carbon. In some embodiments, the first liner material 602 does not include nitrogen.

The first liner layer 610 is conformally deposited over and around the stacks 510, including along the sides and bottom of the etched regions 512, and over the dummy gates 414. The first liner layer 610 may have a thickness of less than 2 nanometers (nm), less than 1.5 nm, less than 1 nm, or less than 0.5 nm, for example.

Returning to FIG. 2, at 210, a second liner is deposited over the first liner. The second liner is a barrier liner that prevents diffusion of oxygen across the second liner, e.g., to prevent oxygen from diffusing into the stacks 510 and damaging the channel material 104. The second liner may be a nitride liner, such as silicon nitride (SiN). The second liner is conformally deposited over the first liner.

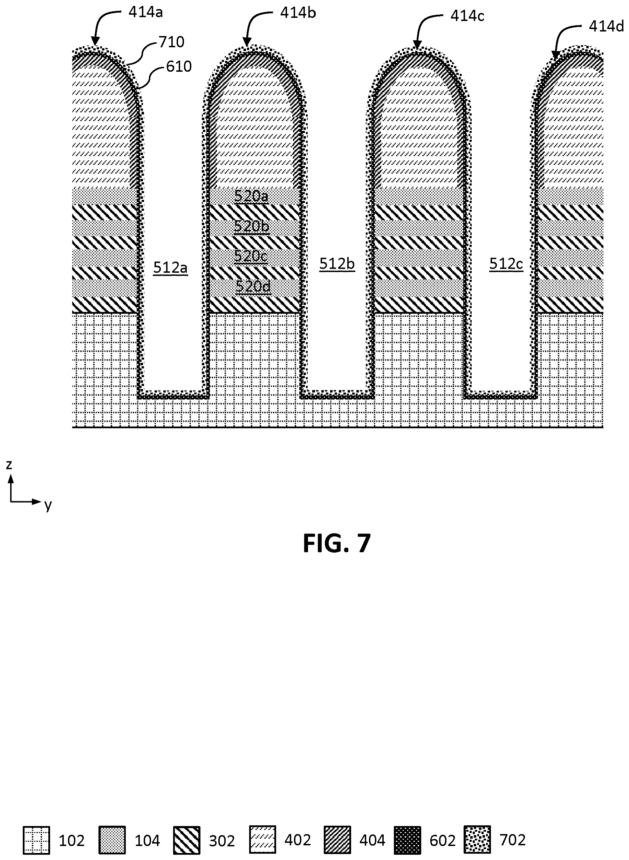

FIG. 7 is a cross-section illustrating a second liner layer 710 deposited over the first liner layer 610. The second liner layer 710 is formed from a second liner material 702. The second liner material 702 includes nitrogen. The second liner material 702 may include silicon. The second liner material 702 may further include one or more other elements, e.g., carbon (SiCN), oxygen (SiOC), or carbon and oxygen (SiOCN).

The second liner layer 710 is conformally deposited over the first liner layer 610. Like the first liner layer 610, the second liner layer 710 is deposited over and around the stacks 510, including along the sides and bottom of the etched regions 512, and over the dummy gates 414. The second liner layer 710 may have a thickness of less than 5 nm, less than 4 nm, less than 3 nm, between 1 and 5 nm, between 1 and 4 nm, or within some other range.

Returning to FIG. 2, at 212, a flowable oxide is deposited over the second liner. A flowable oxide may be deposited by flowing the oxide material over a structure, in this case, over a wafer that includes stacks 510 covered by the two liner layers 610 and 710. The flowable oxide fills into the gaps and voids in the structure, e.g., into the etched regions 512. After depositing the flowable oxide, at 214, the oxide is annealed. For example, the wafer is heated, which causes the flowable oxide to harden. The annealing process may also reduce porousness of the oxide.

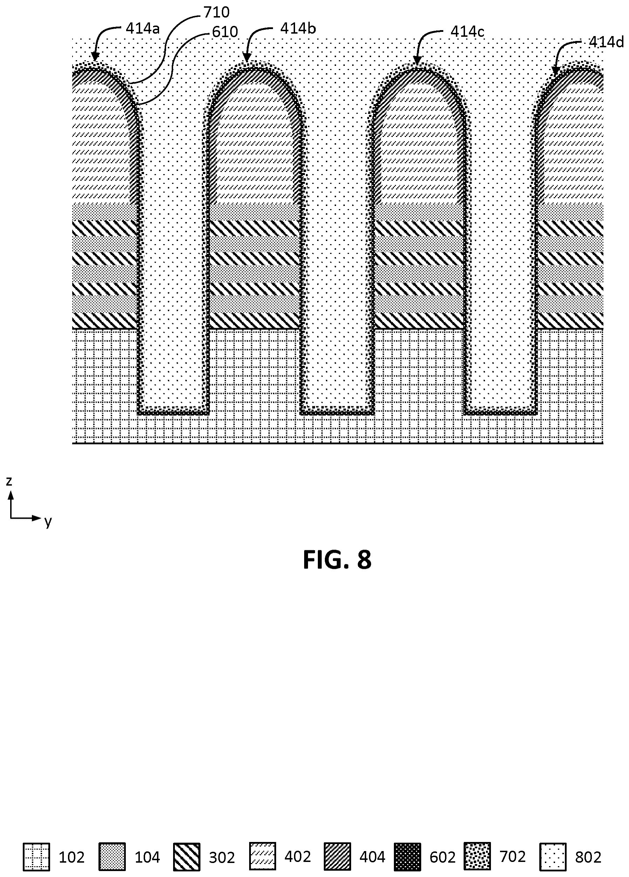

FIG. 8 is a cross-section illustrating an isolation material 802 deposited over the liner layers 610 and 710, according to some embodiments of the present disclosure. The isolation material 802 may be a flowable oxide that has been annealed. The isolation material 802 may include oxygen and one or more other elements, e.g., silicon and oxygen. The isolation material 802 is a dielectric material.

As described above, oxidization of the stacks 510 can damage the channel material 104. For example, oxidization of silicon in the sacrificial material 302 may cause germanium to migrate from the sacrificial material 302 into the channel material 104, which is undesirable. The second liner layer 710 acts as a diffusion barrier that prevents oxygen from the isolation material 802 from moving into the stacks 510. Thus, the second liner layer 710 protects the stacks 510 (and, in particular, the channel material 104) during the oxide annealing process. While nitrogen-based materials are suitable for diffusion barriers, the nitrogen in the second liner material 702may put stress onto the channel material 104 if the second liner material 702 is formed directly over the stacks 510. To prevent stress to the channel material 104 by the second liner layer 710, the first liner layer 610 is between the second liner layer 710 and the stacks 510.

Returning to FIG. 2, at 216, the oxide is recessed to form isolation regions. For example, upper portions of the isolation material 802 over the dummy gates 414 and around the stacks 510 are etched, with portions of the isolation material 802 within the support structure 102 remaining. The isolation regions may be referred to as shallow trench isolation (STI). The oxide may be recessed according to known methods for recessing STI, e.g., wet etching and/or dry etching.

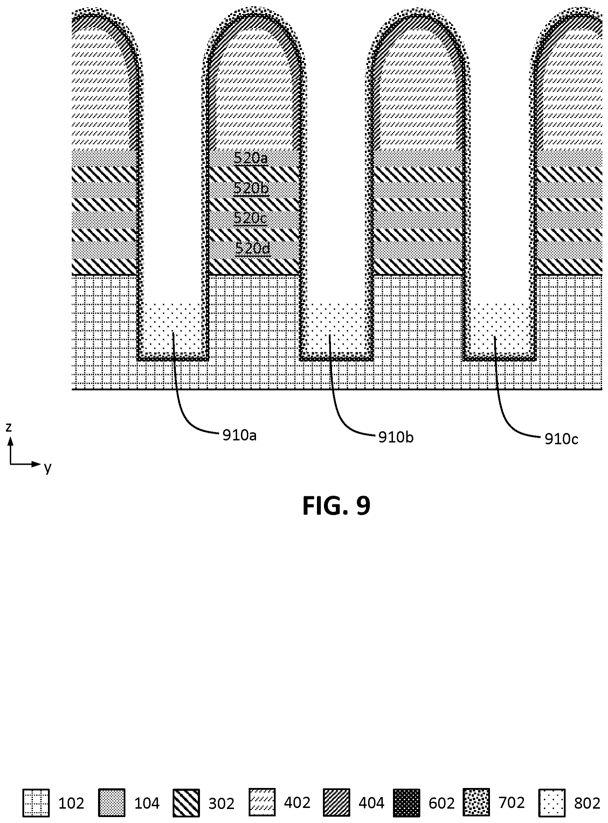

FIG. 9 is a cross-section illustrating the recessed isolation material, according to some embodiments of the present disclosure. FIG. 9 illustrates three isolation regions 910a, 910b, and 910c, which include the isolation material 802. Upper surfaces of the isolation regions 910 are below a lower surface of the lowermost nanoribbon 520d. In this example, the upper surface of each isolation region 910 is also below an upper surface of the support structure 102, such that the isolation regions 910 are recessed within the support structure 102. In other embodiments, the upper surfaces of the isolation regions 910 may be flush with or above the upper surface of the support structure 102.

Returning to FIG. 2, at 218, the first and second liners are removed. As described above, the first and second liners are to protect the channel material 104 during formation of the isolation regions 910, and can be removed after the isolation regions 910 have been deposited, annealed, and recessed. For example, the first liner layer 610 and second liner layer 710 may be removed using one or more etching processes, e.g., a first etching process for removing the second liner layer 710, followed by a second etching process for removing the first liner layer 610.

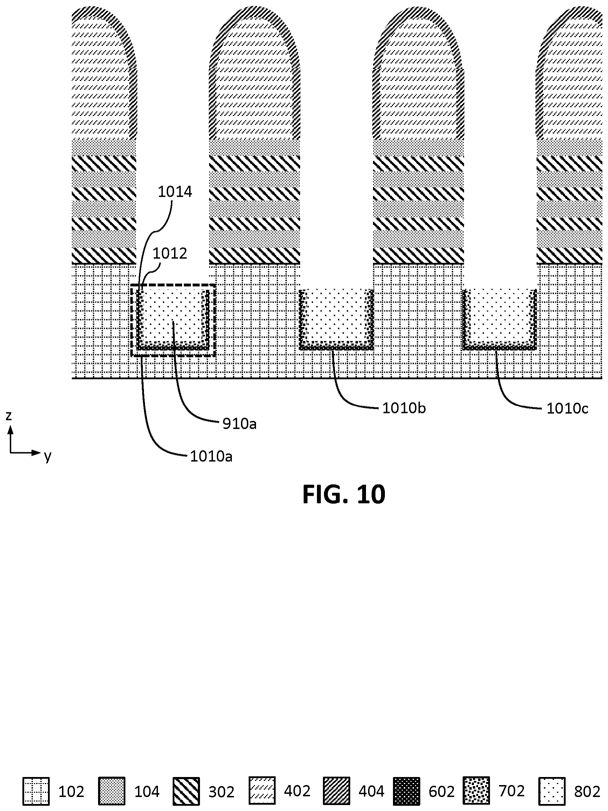

FIG. 10 is a cross-section illustrating the removal of the liner materials in areas above the isolation material, according to some embodiments of the present disclosure. In FIG. 10, the first liner material 602 and second liner material 702 have been removed from areas over the dummy gates 414 and along the channel material 104 and sacrificial material 302. The portions of the first liner material 602 and second liner material 702 next to and under the isolation regions 910 remain, forming a first liner 1012 of the second liner material 702 and a second liner 1014 of the first liner material 602. The presence of the isolation regions 910 over the first liner 1012 and second liner 1014 may block removal of these portions of the first liner material 602 and second liner material 702. The first liner 1012 extends along the sides and base of each isolation region 910. The second liner 1014 extends along the sides and base of the first liner 1012. The first liner 1012 is between the second liner 1014 and the isolation regions 910, and the second liner 1014 is between the first liner 1012 and the support structure 102. The first liner 1012, second liner 1014, and isolation regions 910 together form a lined isolation region 1010. For example, the first liner 1012, second liner 1014, and isolation region 910a form a lined isolation region 1010a.

While the tops of the first liner 1012 and second liner 1014 are illustrated as being aligned with the tops of the isolation regions 910, in some embodiments, the first liner 1012 and/or second liner 1014 may be recessed with respect to the isolation regions 910, due to the etching process. The etching process to remove the first liner material 602 and second liner material 702 does not fully remove the first liner material 602 and second liner material 702 along the full height of the isolation regions 910, or from along the bases of the isolation regions 910, thus the first liner 1012 and second liner 1014 of the lined isolation regions 1010 remain.

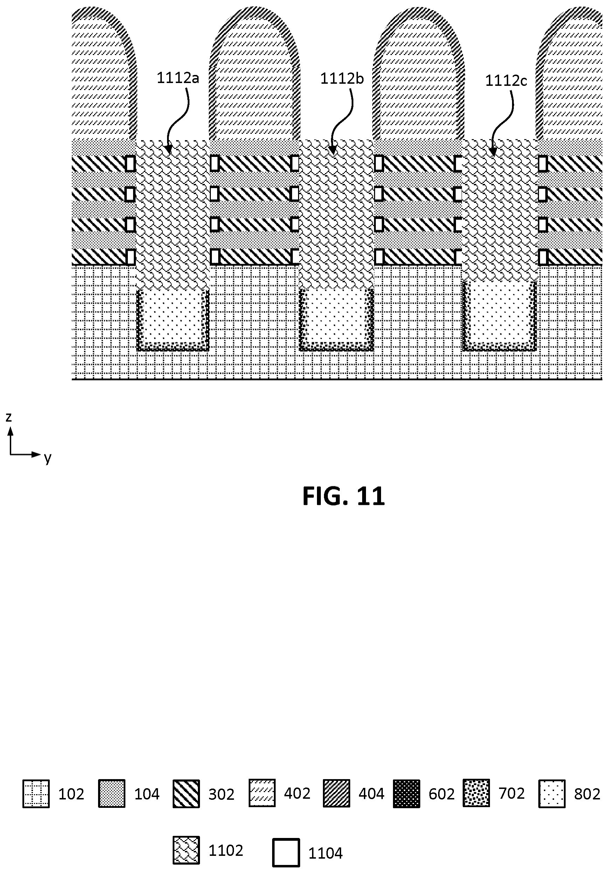

Returning to FIG. 2, at 220, source and drain material is deposited along the ends of the nanoribbons 520, and over the lined isolation regions 1010. In some embodiments, prior to depositing the source and drain material, ends of the sacrificial material 302 adjacent to the etched regions 512 are recessed, and cavity spacers are formed. FIG. 11 is a cross-section illustrating growth of sources and drains. FIG. 11 illustrates that an S/D material 1102 has been deposited in the spaces between ends of the nanoribbons 520 and over the lined isolation regions 1010, forming the S/D contacts 1112a-1112c. The S/D material 1102 may include any of the materials described with respect to the S/D contacts 108. In this example, each S/D contact 1112 is shared by two transistors, each transistor formed around a respective nanoribbon stack 510. For example, the S/D contact 1112b is shared by the transistors formed around the nanoribbon stacks 1110b and 1110c; in one embodiment, the S/D contact 1112b is a drain contact for the nanoribbon stack 510b and a source contact for the nanoribbon stack 510c. FIG. 11 also illustrates cavity spacers 1104 formed between adjacent nanoribbons 520 and adjacent to the S/D contacts 1112. The cavity spacers 1104 may be similar to the cavity spacers 130 of FIG. 1.

Returning to FIG. 2, at 222, a gate stack is formed around the nanoribbon stacks. For example, the remainder of the sacrificial material and the dummy gate material are removed, exposing the central portions of the nanoribbon channels. This etching process leaves the nanoribbon channels "floating" and supported by the S/D contacts and the cavity spacers. After this etching process, a gate stack including one or more gate dielectrics and one or more conductors are grown around the exposed portions of the nanoribbons.

FIG. 12A is a cross-section illustrating formation of the gate stack. FIG. 12A illustrates that the dummy gate material 402 has been removed (while the gate spacer 404 remains in an area above the S/D contacts 1112). The tops of the dummy gates 414 may have been removed in a polishing or planarization process, exposing the dummy gate material 402. In some embodiments, the polishing or planarization process may have been performed at an earlier stage in the process, e.g., after annealing the isolation material 802 but before recessing the isolation material 802. The dummy gate material 402 may be removed using a chemical etching process, e.g., a dry or wet etch. After removal of the dummy gate material 402, the sacrificial material 302 between the channel material 104 in the nanoribbon stacks 510 is removed, e.g., using a second etching process. After removal of the sacrificial material 302, gate material 1202 is grown around the centers of the nanoribbons 520, forming the gates 1210a-1210d. For example, the gate stack 1210b is formed around the nanoribbons 520a-520c. The gate material 1202 may include multiple gate materials grown in layers, e.g., a layer of dielectric directly over the nanoribbons 520 followed by a layer of a conductive material forming the gate electrode. For example, the gates 1210 may include the oxide 112, gate dielectric 114, and gate electrode 110 illustrated in FIG. 1 and described above.

FIG. 12B is an enlarged view of a portion 1220 of FIG. 12A, illustrating one of the lined isolation regions 1010b in greater detail. The isolation region 1010b includes the first liner 1012 and second liner 1014. The first liner 1012 includes a first liner portion 1212a, a second liner portion 1212b, and a third liner portion 1212c. The first liner portion 1212a is along a first sidewall of the isolation region 910b, and the second liner portion 1212b is along a second sidewall of the isolation region 910b, where the first sidewall is opposite the second sidewall. The isolation region 910b is between the lined isolation region first liner portion 1212a and second liner portion 1212b. The third liner portion 1212c is along a base of the isolation region 910b.

The second liner 1214 includes a first liner portion 1214a, a second liner portion 1214b, and a third liner portion 1214c. The first liner portion 1214a of the second liner 1014 is along the first liner portion 1212a of the first liner 1012, and the second liner portion 1214b of the second liner 1014 is along the second liner portion 1212b of the first liner 1012. The third liner portion 1214c of the second liner 1014 is along the third liner portion 1212c of the first liner 1012.

The liners 1012 and 1014 are each within the same layer as the isolation regions 910, which are within a same layer as the support structure 102. The first liner 1012, second liner 1014, and isolation regions 910 are each in a layer below the nanoribbons 520. For example, the nanoribbons 520 are in a transistor layer or device layer, while the lined isolation regions 1010 are within a substrate layer or support structure layer. The first liner 1012 is nested within the second liner 1014, and the isolation region 910b is nested within the first liner 1012. In some embodiments, the isolation regions 910 are partially nested within the first liner 1012 and/or second liner 1014, if one or both of the liners 1012 and 1014 are recessed below a top of the isolation regions 910, as described above.

In some embodiments, the lined isolation regions 1010 may not include liner materials along their bases, e.g., the third liner portion 1212c of the first liner 1012 or the third liner portion 1214c of the second liner 1014. For example, if the substrate 102 is thinned from a backside, the grinding may remove the third liner portion 1212c of the first liner 1012 or the third liner portion 1214c of the second liner 1014. The grinding may further remove lower portions of the isolation regions 910 as well as lower portions of the liners along the sidewalls, e.g., lower portions of the portions 1214a and 1214b of the second liner 1014, and lower portions of the portions 1212a and 1212b of the first liner 1012.

An outer edge of the second liner 1014 may be aligned with or substantially aligned (e.g., within 5 nm or alignment, within 3 nm of alignment, within 2 nm of alignment, within 1 nm of alignment, or within some other tolerance) with edges of the nanoribbons 520 and corresponding edges of the S/D contacts 1112. In FIG. 12B, a vertical line 1230 is drawn along an outer edge of the first liner portion 1214a, a sidewall of the S/D contact 1112b, and edges of the nanoribbons 520, illustrating alignment of these features. In some cases, the first liner 1012 and second liner 1014 are jointly considered the liner with the liner having two layers (a layer of the first liner material 602 and a layer of the second liner material 702). In this way, the liner (comprising the first liner material 602 and second liner material 702) is aligned or substantially aligned with the edges of the S/D contact 1112 and nanoribbons 520. Said another way, if the second liner 1014 has a width of, e.g., 2 nm or less (e.g., the first liner portion 1214a has a width in the y-direction of 2 nm or less), an outer edge of the first liner 1012 is offset from edges of the nanoribbons 520 and the left edge of the S/D contact 1112 by 2 nm or less.

### Example devices

The circuit devices with nanoribbon transistors with lined isolation regions disclosed herein may be included in any suitable electronic device. FIGS. 13-16 illustrate various examples of apparatuses that may include the one or more transistors disclosed herein, which may have been fabricated using the processes disclosed herein.

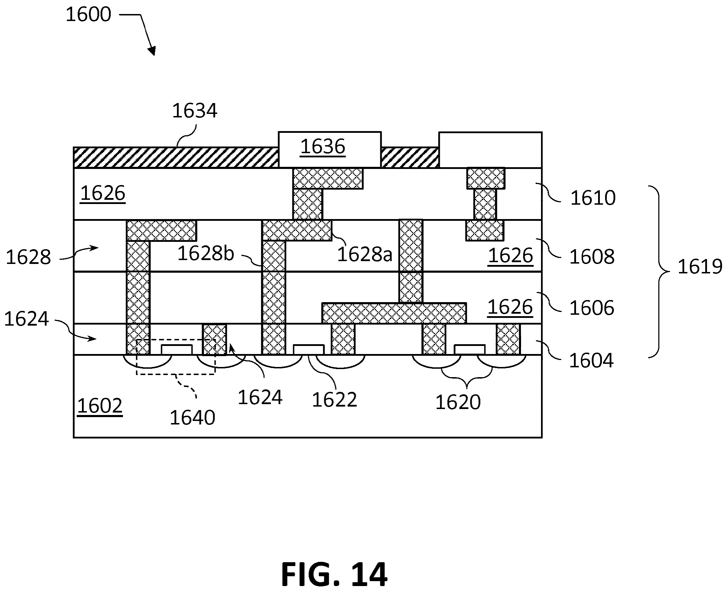

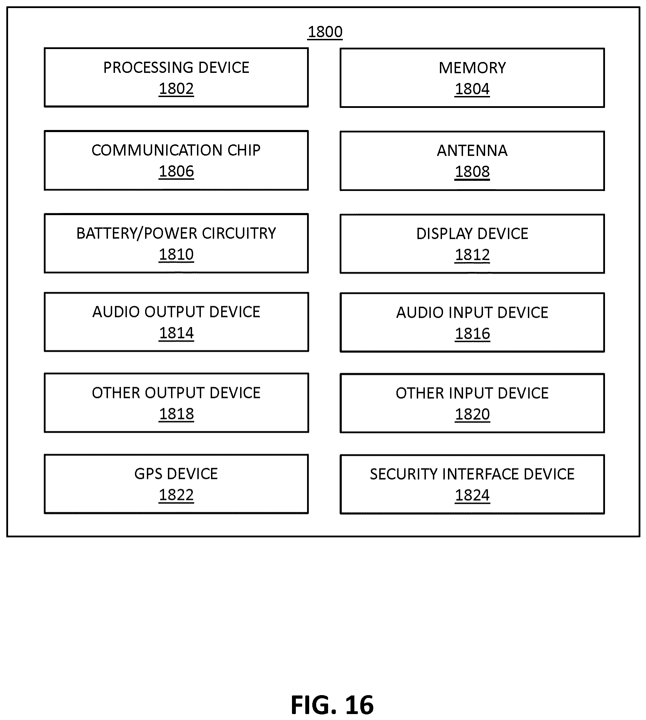

FIG. 13A and 13B are top views of a wafer and dies that include one or more IC structures including one or more nanoribbon transistors with lined isolation regions in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC structure (e.g., the IC structures as shown in any of FIGS. 2-14, or any further embodiments of the IC structures described herein). After the fabrication of the semiconductor product is complete (e.g., after manufacture of one or more IC structures with one or more of the transistors as described herein, included in a particular electronic component, e.g., in a transistor or in a memory device), the wafer 1500 may undergo a singulation process in which each of the dies 1502 is separated from one another to provide discrete "chips" of the semiconductor product. In particular, devices that include one or more of the transistors as disclosed herein may take the form of the wafer 1500 (e.g., not singulated) or the form of the die 1502 (e.g., singulated). The die 1502 may include one or more transistors (e.g., one or more of the transistors 1640 of FIG. 14, discussed below) and/or supporting circuitry to route electrical signals to the transistors, as well as any other IC components (e.g., one or more of the non-planar transistors described herein). In some embodiments, the wafer 1500 or the die 1502 may include a memory device (e.g., an SRAM device), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 16) or other logic that is configured to store information in the memory devices or execute instructions stored in the memory array.

FIG. 14 is a cross-sectional side view of an IC device 1600 that may include one or more nanoribbon transistors with lined isolation regions in accordance with any of the embodiments disclosed herein. The IC device 1600 may be formed on a substrate 1602 (e.g., the wafer 1500 of FIG. 13A) and may be included in a die (e.g., the die 1502 of FIG. 13B). The substrate 1602 may be any substrate as described herein. The substrate 1602 may be part of a singulated die (e.g., the dies 1502 of FIG. 13B) or a wafer (e.g., the wafer 1500 of FIG. 13A).

The IC device 1600 may include one or more device layers 1604 disposed on the substrate 1602. The device layer 1604 may include features of one or more transistors 1640 (e.g., metal-oxide-semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 14 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross-section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The IC device 1600 may include one or more nanoribbon transistors with lined isolation regions at any suitable location in the IC device 1600.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 14 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 14). Although a particular number of interconnect layers 1606-1610 is depicted in FIG. 14, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 14. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 14. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

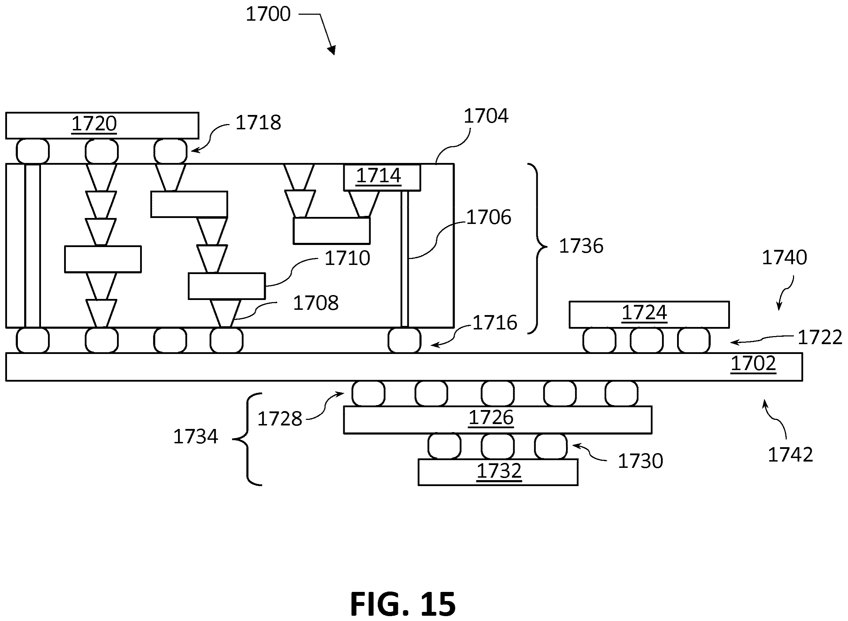

FIG. 15 is a cross-sectional side view of an IC device assembly 1700 that may include components having or being associated with (e.g., being electrically connected by means of) one or more nanoribbon transistors with lined isolation regions in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include one or more of the non-planar transistors disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 15 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 15), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 15, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 13B), an IC device (e.g., the IC device 1600 of FIG. 14), or any other suitable component. In some embodiments, the IC package 1720 may include one or more nanoribbon transistors with lined isolation regions, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 15, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 15 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 16 is a block diagram of an example computing device 1800 that may include one or more nanoribbon transistors with lined isolation regions in accordance with any of the embodiments disclosed herein. For example, any suitable ones of the components of the computing device 1800 may include a die (e.g., the die 1502 (FIG. 13B)) having one or more nanoribbon transistors with lined isolation regions. Any one or more of the components of the computing device 1800 may include, or be included in, an IC device 1600 (FIG. 14). Any one or more of the components of the computing device 1800 may include, or be included in, an IC device assembly 1700 (FIG. 15).

A number of components are illustrated in FIG. 16 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 16, but the computing device 1800 may include interface circuitry for coupling to the one or more components. For example, the computing device 1800 may not include a display device 1812, but may include display device interface circuitry (e.g., a connector and driver circuitry) to which a display device 1812 may be coupled. In another set of examples, the computing device 1800 may not include an audio input device 1816 or an audio output device 1814, but may include audio input or output device interface circuitry (e.g., connectors and supporting circuitry) to which an audio input device 1816 or audio output device 1814 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random access memory (eDRAM) or spin transfer torque magnetic random access memory (STT-MRAM).

In some embodiments, the computing device 1800 may include a communication chip 1806 (e.g., one or more communication chips). For example, the communication chip 1806 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1806 may implement any of a number of wireless standards or protocols, including but not limited to Institute for Electrical and Electronic Engineers (IEEE) standards including Wi-Fi (IEEE 1402.11 family), IEEE 1402.18 standards (e.g., IEEE 1402.18-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.18 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.18 standards. The communication chip 1806 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1806 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1806 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1806 may operate in accordance with other wireless protocols in other embodiments. The computing device 1800 may include an antenna 1808 to facilitate wireless communications and/or to receive other wireless communications (such as AM or FM radio transmissions).

In some embodiments, the communication chip 1806 may manage wired communications, such as electrical, optical, or any other suitable communication protocols (e.g., the Ethernet). As noted above, the communication chip 1806 may include multiple communication chips. For instance, a first communication chip 1806 may be dedicated to shorter-range wireless communications such as Wi-Fi or Bluetooth, and a second communication chip 1806 may be dedicated to longer-range wireless communications such as GPS, EDGE, GPRS, CDMA, WiMAX, LTE, EV-DO, or others. In some embodiments, a first communication chip 1806 may be dedicated to wireless communications, and a second communication chip 1806 may be dedicated to wired communications.

The computing device 1800 may include a battery/power circuitry 1810. The battery/power circuitry 1810 may include one or more energy storage devices (e.g., batteries or capacitors) and/or circuitry for coupling components of the computing device 1800 to an energy source separate from the computing device 1800 (e.g., AC line power).

The computing device 1800 may include a display device 1812 (or corresponding interface circuitry, as discussed above). The display device 1812 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1814 (or corresponding interface circuitry, as discussed above). The audio output device 1814 may include any device that generates an audible indicator, such as speakers, headsets, or earbuds, for example.

The computing device 1800 may include an audio input device 1816 (or corresponding interface circuitry, as discussed above). The audio input device 1816 may include any device that generates a signal representative of a sound, such as microphones, microphone arrays, or digital instruments (e.g., instruments having a musical instrument digital interface (MIDI) output).

The computing device 1800 may include another output device 1818 (or corresponding interface circuitry, as discussed above). Examples of the other output device 1818 may include an audio codec, a video codec, a printer, a wired or wireless transmitter for providing information to other devices, or an additional storage device.

The computing device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may include a global positioning system (GPS) device 1822 (or corresponding interface circuitry, as discussed above). The GPS device 1822 may be in communication with a satellite-based system and may receive a location of the computing device 1800, as known in the art.

The computing device 1800 may include a security interface device 1824. The security interface device 1824 may include any device that provides security features for the computing device 1800 or for any individual components therein (e.g., for the processing device 1802 or for the memory 1804). Examples of security features may include authorization, access to digital certificates, access to items in keychains, etc. Examples of the security interface device 1824 may include a software firewall, a hardware firewall, an antivirus, a content filtering device, or an intrusion detection device.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

### Select examples

The following paragraphs provide various examples of the embodiments disclosed herein.

Example 1 provides an integrated circuit (IC) device including a first semiconductor channel of a first transistor; a second semiconductor channel of a second transistor, the first semiconductor channel and the second semiconductor channel in a first layer; an isolation region in a second layer below the first layer, the isolation region including oxygen, and the isolation region arranged laterally between the first semiconductor channel and the second semiconductor channel, the isolation region having a base, a first sidewall, a second sidewall, and a top; and a liner along the base, first sidewall, and second sidewall, the liner including nitrogen.

Example 2 provides the IC device of example 1, where the isolation region includes oxygen.

Example 3 provides the IC device of example 1 or 2, where the liner further includes silicon.

Example 4 provides the IC device of any preceding example, where the liner has a thickness of less than 5 nanometers.

Example 5 provides the IC device of any preceding example, where the liner includes a first liner layer and a second liner layer, the first liner layer including nitrogen, the second liner layer including oxygen, where the first liner layer is nested within the second liner layer, and the isolation region is nested within the first liner layer.

Example 6 provides the IC device of example 5, where the second liner layer has a thickness of less than 2 nanometers.

Example 7 provides the IC device of any preceding example, where the second layer is a substrate layer including a substrate material, and the liner is between the substrate material and the isolation region.

Example 8 provides the IC device of example 7, where the isolation region and the liner are recessed within the substrate layer.

Example 9 provides the IC device of any preceding example, where an edge of the first semiconductor channel is vertically aligned with a first portion of the liner, and an edge of the second semiconductor channel is vertically aligned with a second portion of the liner.

Example 10 provides the IC device of any preceding example, where the first semiconductor channel is a first nanoribbon in a first stack of nanoribbons, and the second semiconductor channel is a second nanoribbon in a second stack of nanoribbons.

Example 11 provides the IC device of any preceding example, where the first layer further includes a source or drain region between the first semiconductor channel and the second semiconductor channel, and the isolation region is under the source or drain region.

Example 12 provides an integrated circuit (IC) device including a substrate; a stack of nanoribbons over the substrate; a source or drain (S/D) region coupled to the stack of nanoribbons; a dielectric region in the substrate and below the S/D region; and a liner between the dielectric region and the substrate, the liner including nitrogen.

Example 13 provides the IC device of example 12, where the dielectric region includes oxygen.

Example 14 provides the IC device of example 12 or 13, where the liner includes silicon.

Example 15 provides the IC device of any of examples 12-14, where the liner includes a first portion along a first side of the dielectric region, a second portion along a second side of the dielectric region, and a third portion along a base of the dielectric region.

Example 16 provides the IC device of any of examples 12-15, where the liner has a thickness of less than 5 nanometers.

Example 17 provides the IC device of any of examples 12-16, where the liner is a first liner, the IC device further including a second liner including oxygen, where the second liner is between the first liner and the substrate.

Example 18 provides the IC device of any preceding example, where the second liner has a thickness of less than 2 nanometers.

Example 19 provides a method including providing a stack of alternating materials over a substrate, the stack including a first material and a second material; etching portions of the stacked materials and portions of the substrate, the etched portions of the substrate below the etched portions of the stacked materials; depositing a liner material over the stacked materials and substrate, the liner including nitrogen; depositing a dielectric material over the liner, the dielectric material including oxygen; annealing the dielectric material; removing portions of the dielectric material in a same layer as the stack of alternating materials; and removing portions of the liner material in the same layer as the stack of alternating materials.

Example 20 provides the method of example 19, where portions of the dielectric material in a same layer as a substrate and portions of the liner material in the same layer as the substrate are not removed.

Example 21 provides an IC package that includes an IC die, including one or more of the IC devices according to any one of the preceding examples. The IC package may also include a further component, coupled to the IC die.

Example 22 provides the IC package according to example 21, where the further component is one of a package substrate, a flexible substrate, or an interposer.

Example 23 provides the IC package according to examples 21 or 22, where the further component is coupled to the IC die via one or more first level interconnects.

Example 24 provides the IC package according to example 23, where the one or more first level interconnects include one or more solder bumps, solder posts, or bond wires.

Example 25 provides a computing device that includes a circuit board; and an IC die coupled to the circuit board, where the IC die includes one or more of the transistor/IC devices according to any one of the preceding examples (e.g., transistor/IC devices according to any one of examples 1-20), and/or the IC die is included in the IC package according to any one of the preceding examples (e.g., the IC package according to any one of examples 21-24).

Example 26 provides the computing device according to example 25, where the computing device is a wearable computing device (e.g., a smart watch) or hand-held computing device (e.g., a mobile phone).

Example 27 provides the computing device according to examples 25 or 26, where the computing device is a server processor.

Example 28 provides the computing device according to examples 25 or 26, where the computing device is a motherboard.

Example 29 provides the computing device according to any one of examples 25-28, where the computing device further includes one or more communication chips and an antenna.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device comprising:
a first semiconductor channel of a first transistor;
a second semiconductor channel of a second transistor, the first semiconductor channel and the second semiconductor channel in a first layer;
an isolation region in a second layer below the first layer, the isolation region comprising oxygen, and the isolation region arranged laterally between the first semiconductor channel and the second semiconductor channel, the isolation region having a base, a first sidewall, a second sidewall, and a top; and
a liner along the base, the first sidewall, and the second sidewall, the liner comprising nitrogen.

2. The IC device of claim 1, wherein the isolation region comprises oxygen.

3. The IC device of claim 1 or 2, wherein the liner further comprises silicon.

4. The IC device of any preceding claim, wherein the liner has a thickness of less than 5 nanometers.

5. The IC device of any preceding claim, wherein the liner comprises a first liner layer and a second liner layer, the first liner layer comprising nitrogen, the second liner layer comprising oxygen, wherein the first liner layer is nested within the second liner layer, and the isolation region is nested within the first liner layer.

6. The IC device of claim 5, wherein the second liner layer has a thickness of less than 2 nanometers.

7. The IC device of any preceding claim, wherein the second layer is a substrate layer comprising a substrate material, and the liner is between the substrate material and the isolation region.

8. The IC device of claim 7, wherein the isolation region and the liner are recessed within the substrate layer.

9. The IC device of any preceding claim, wherein an edge of the first semiconductor channel is vertically aligned with a first portion of the liner, and an edge of the second semiconductor channel is vertically aligned with a second portion of the liner.

10. The IC device of any preceding claim, wherein the first semiconductor channel is a first nanoribbon in a first stack of nanoribbons, and the second semiconductor channel is a second nanoribbon in a second stack of nanoribbons.

11. The IC device of any preceding claim, wherein the first layer further comprises a source or drain region between the first semiconductor channel and the second semiconductor channel, and the isolation region is under the source or drain region.

12. A method comprising:
providing a stack of alternating materials over a substrate, the stack comprising a first material and a second material;
etching portions of the stacked materials and portions of the substrate, the etched portions of the substrate below the etched portions of the stacked materials;
depositing a liner material over the stacked materials and substrate, the liner comprising nitrogen;
depositing a dielectric material over the liner, the dielectric material comprising oxygen;
annealing the dielectric material;
removing portions of the dielectric material in a same layer as the stack of alternating materials; and
removing portions of the liner material in the same layer as the stack of alternating materials.

13. The method of claim 12, wherein portions of the dielectric material in a same layer as a substrate and portions of the liner material in the same layer as the substrate are not removed.

14. The method of claim 12 or 13, wherein the liner has a thickness of less than 2 nanometers.

15. The method of any of claims 12-14, further comprising depositing a second liner material, the second liner material comprising oxygen, wherein the liner material is nested within the second liner material.
